(19) Europäisches Patentamt

European Patent Office

Office européen des brevets

(11) **EP 1 693 967 A1**

(12) **EUROPEAN PATENT APPLICATION**
published in accordance with Art. 158(3) EPC

(43) Date of publication:
**23.08.2006 Bulletin 2006/34**

(51) Int Cl.:
*H03L 7/197* (2006.01)     *H03L 7/183* (2006.01)
*H03M 7/32* (2006.01)

(21) Application number: **04820278.2**

(22) Date of filing: **09.12.2004**

(86) International application number:
**PCT/JP2004/018405**

(87) International publication number:
**WO 2005/057793 (23.06.2005 Gazette 2005/25)**

(84) Designated Contracting States:
**DE FR NL**

(30) Priority: **10.12.2003 JP 2003411776**

(71) Applicant: **MATSUSHITA ELECTRIC INDUSTRIAL CO., LTD.**
**Kadoma-shi, Osaka 571-8501 (JP)**

(72) Inventors:
• **SAEKI, Takaharu**
**Matsushita Electric Ind. Co., Ltd.**
**Shiromi 1-chome**
**Chuo-ku**
**Osaka 540-6319 (JP)**

• **MAEDA, Masakatsu**
**Matsushita Electric Ind. Co., Ltd**
**Shiromi 1-chome**
**Chuo-ku**
**Osaka 540-6319 (JP)**

(74) Representative: **TBK-Patent**
**Bavariaring 4-6**
**80336 München (DE)**

(54) **DELTA-SIGMA TYPE FRACTION DIVISION PLL SYNTHESIZER**

(57)     An object is to achieve reduction of a spurious in a delta-sigma type fraction division PLL synthesizer.

In its configuration, first and second L-value accumulators 31 and 30 are provided. The difference between overflow signals 16 and 17 of the first and the second L-value accumulators 31 and 30 is acquired by an adder 29, so that in response to an output signal of the adder 29, a division ratio of a variable divider 2 having a division ratio switchable between M, M+1, and M-1 is switched. By virtue of this, the frequency of a spurious generated by operation noise of the first and the second L-value accumulators 31 and 30 is shifted to a frequency component higher than the prior art so that the spurious is removed by a loop filter (low pass filter) 5.

Fig. 1

**Description**

TECHNICAL FIELD

The present invention relates to a delta-sigma type fraction division PLL synthesizer that allows reduction of an output spurious. In particular, the present invention relates to a delta-sigma type fraction division PLL synthesizer that allows characteristics improvement in comparison with the prior art.

BACKGROUND ART

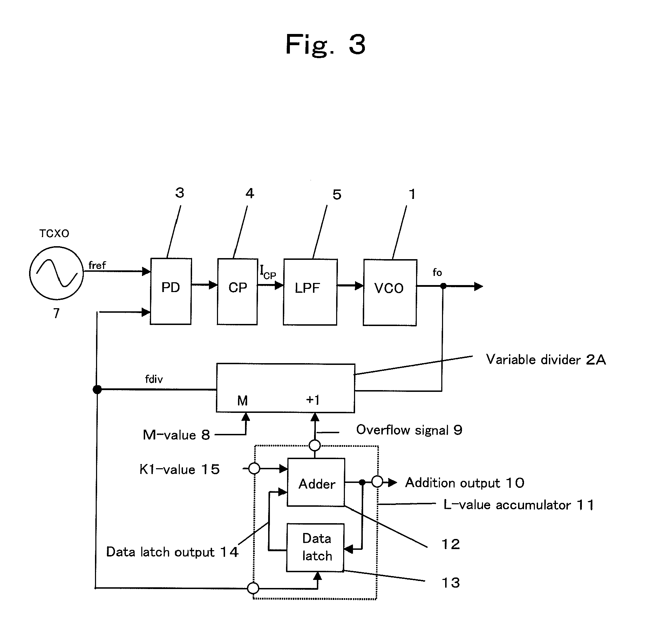

Fig. 3 is a block diagram of a prior art of a delta-sigma type fraction division PLL synthesizer. In this delta-sigma type fraction division PLL synthesizer, a reference signal fref outputted from a temperature compensated oscillator (TCXO) 7 is applied on one input terminal of a phase comparator (PD) 3. Further, an output signal fo of a voltage controlled oscillator (VCO) 1 is frequency-divided by a variable divider 2A and then outputted as a signal fdiv. The signal fdiv outputted from the variable divider 2A is applied on the other input terminal of the phase comparator 3. As a result, the phase difference between the reference signal fref and the signal fdiv is detected by the phase comparator (PD) 3. Then, a voltage pulse having a pulse width corresponding to the phase difference between the reference signal fref and the signal fdiv is transmitted from the phase comparator 3 to a charge pumping circuit (CP) 4.

From the charge pumping circuit 4, a charge pump output current Icp is outputted that can take any one of the states of discharging and suctioning of the current and the state of high impedance (Hi-Z) in response to the voltage pulse outputted from the phase comparator 3. The charge pump output current Icp is smoothed by a loop filter 5 constructed from a low pass filter, then converted into a voltage, and then inputted as a control voltage to the voltage controlled oscillator 1.

As described above, the output signal fo of the voltage controlled oscillator 1 is frequency-divided by the variable divider 2A and then fed back as the comparison signal fdiv to the phase comparator 3.

Thus, when the division ratio of the variable divider 2A is expressed by [M+(K/L)] while the frequency of the reference signal fref is denoted by fref, the frequency of the output signal fo of the voltage controlled oscillator 1 (the frequency is denoted by the same symbol fo as the output signal fo itself, for simplicity) is expressed as follows.

$$fo=[M+(K/L)] \times fref \ \ldots(1)$$

Here, M, K, L: positive integer values,
M: integer part division ratio, and
K/L: decimal part division ratio.

The variable divider 2A is provided with: an integer division ratio input terminal for inputting a value 8 of the integer part division ratio M; and a division ratio switching terminal for inputting a signal for changing the division ratio from M to M+1. This configuration allows the division ratio to be switched to M or (M+1). Specifically, the variable divider 2A usually has a division ratio of M. Then, only when a division ratio switching signal is inputted to the division ratio switching terminal, the division ratio is changed into (M+1). This realizes an average division ratio of [M+(K/L)].

Such changing of the division ratio can be implemented by an L-value accumulator 11 that constitutes a delta sigma section. Specifically speaking, an overflow signal 9 of the L-value accumulator 11 is inputted to the division ratio switching terminal of the variable divider 2A. Thus, only when the overflow signal 9 is generated in the L-value accumulator 11, the division ratio of the variable divider 2A becomes (M+1). This realizes an average division ratio of [M+(K/L)].

The L-value accumulator 11 generates an overflow signal 9 when the accumulated value reaches a value L. Specifically, the L-value accumulator 11 is constructed from: an L-value adder 12 that receives a K-value 15 as one input; and a data latch 13 for providing its own hold value, that is, a data latch output 14, to the L-value adder 12 as the other input. The data latch 13 holds an addition output 10 of the L-value adder 12 in response to the reference signal fref or the signal fdiv.

By virtue of this configuration, in the L-value accumulator 11, its output increases by a value K in response to a clock (signal) equal to the reference signal fref or the signal fdiv. Then, when overflow occurs in the L-value adder 12, the division ratio becomes M+1. During the time that no overflow signal 9 is generated, the division ratio remains at M (see, for example, Non-Patent Document 1).

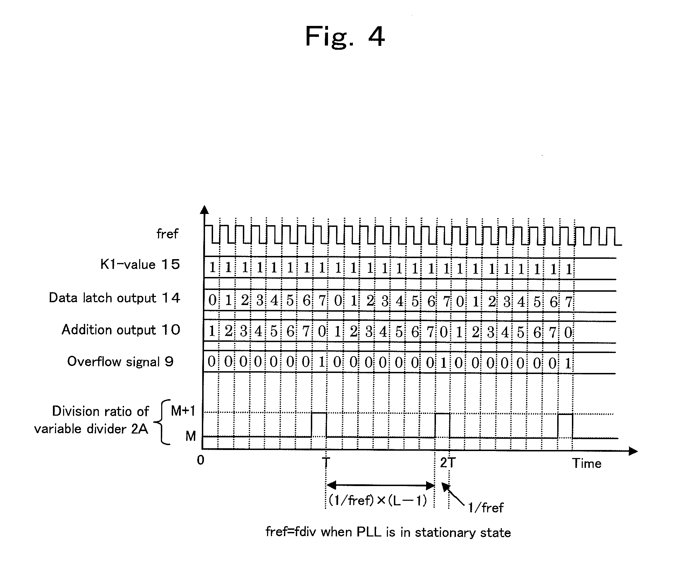

Principles of operation of the delta sigma section are described below with reference to Fig. 4. Fig. 4 shows: the reference signal fref; the K-value 15 inputted to the adder 12; the output 14 of the data latch 12; the output 10 of the adder 12; the overflow signal 9; and the division ratio of the variable divider 2A, in the case of a division ratio=K/L=1/8.

In the fraction division PLL synthesizer, the division ratio of a usual variable frequency divider 2A is changed time-dependently so that a division ratio having a fraction value is realized as the averaged value. When the one period of the reference signal fref=1/fref is defined as one clock time, the division ratio changes from M to M+1 once during L clock times (duration T). In this case, the average of the division ratio in the duration T is expressed by M+(1/L). This term (1/L) of fraction part can be extended into (K/L). That is, in the case of K=1, 2, 3..., the division ratio can be set up by the (1/L) step unit.

Further, in general, it is known that when a "MASH" is formed by connecting a plurality of delta sigma circuits, noise characteristics is improved in the delta sigma configuration (see, for example, Non-Patent Document 2).

Patent Document 1: JP-A No. 2000-052044
Patent Document 2: JP-A No. H05-500894

Non-Patent Document 1: The Institute of Electronics, Information and Communication Engineers, Transactions C-1, VOL. J76-C-1, NO. 11, pp. 445-452, November 1993, "A High-Speed Frequency Switching Synthesizer Using Fraction Division Method".
Non-Patent Document 2: IEEE JOURNAL OF SOLID-STATE CIRCUITS, VOL. 24, NO. 4, AUGUST 1989, pp. 696, "A 17-bit Oversampling D-to-A Conversion Technology Using Multistage Noise Shaping".
Non-Patent Document 3: IEEE JOURNAL OF SOLID-STATE CIRCUITS, VOL. 38, NO. 5, MAY 2003, pp. 782, "A 17-mW Transmitter and Frequency Synthesizer for 900-MHz GSM Fully Integrated in 0.35-$\mu$m CMOS".

DISCLOSURE OF THE INVENTION

PROBLEMS TO BE SOLVED BY THE INVENTION

Nevertheless, in the configuration of the prior art described above, mainly owing to (a), (b), and (c) described below, a spurious has been generated at a frequency detuned by $\triangle$f=fref$\times$(K/L) relative to the output signal fo of the voltage controlled oscillator 1.

(a) Periodicity of the overflow signal 9.
(b) Leakage of periodic operation noise of the L-value accumulator 11 into the charge pumping circuit 4 and the like.
(c) The case that the decimal part division ratio (K/L) is $1/2^n$.

As for (a), as shown in Non-Patent Document 2, when the L-value accumulators 11 are connected in multi-stage, a countermeasure is achieved in principle.

Nevertheless, among the spurious generated by the cause (b), in the case of a spurious generated when $\Delta$f is small (the frequency is close to the output signal fo of the voltage controlled oscillator 1), that is, a low frequency spurious that cannot be attenuated by the loop filter 5, no essential countermeasure has been available.

Further, as for (c), there has been a problem that a spurious is easily generated in principle.

Thus, an object of the present invention is to provide a delta-sigma type fraction division PLL synthesizer that allows sufficient attenuation in the spurious caused by periodic operation noise of the L-value accumulator, in particular, in the low frequency spurious that has not been removed by a loop filter in the prior art.

MEANS FOR SOLVING THE PROBLEM

A delta-sigma type fraction division PLL synthesizer of the present invention comprises: a voltage controlled oscillator (1); a variable divider (2) that has a division ratio switchable between M (M is a positive integer), (M+1), and (M-1) and performs frequency dividing of an output signal fo of the voltage controlled oscillator (1); a phase comparator (3) for performing phase comparison of an output signal fdiv of the variable divider (2) with a reference signal fref; a filter (5) for smoothing an output signal of the phase comparator (3) and then feed-backs the signal to the voltage controlled oscillator (1); a first L-value accumulator (31) (L is a positive integer) for accumulating a value K1 (18) (K1 is an integer); a second L-value accumulator (30) for accumulating a value K2 (19) (K2 is an integer); and an adder (29) for subtracting an overflow signal (17) of the second L-value accumulator (30) from an overflow signal (16) of the first L-value accumulator (31).

Then, in the delta-sigma type fraction division PLL synthesizer, the values K1 (18) and K2 (19) are set into values that satisfy K1-K2=K and have absolute values larger than a value K (K is a positive integer). Further, an output signal of the adder (29) is provided as a division ratio switching signal to the variable divider (2). As a result, when the output signal of the adder (29) has a zero value, the division ratio of the variable divider (2) is set into M. Further, when the output signal of the adder (29) has a positive value, the division ratio of the variable divider (2) is set into (M+1). Furthermore, when the output signal of the adder (29) has a negative value, the division ratio of the variable divider (2) is set into (M-1). Accordingly, the average division ratio of the variable divider (2) becomes M+(K/L).

Here, the first L-value accumulator (31) is constructed from: a first L-value adder (22) that receives, for example, the value K1 (18) (K1 is an integer) as one input; and a first data latch (24) for providing its own hold value to the first L-value adder (22) as the other input. The first data latch (24) holds an output of the first L-value adder (22) in response to the reference signal fref or the output signal fdiv of the variable divider (2).

Further, the second L-value accumulator (30) is constructed from: a second L-value adder (23) that receives, for example, the value K2 (19) (K2 is an integer) as one input; and a second data latch (25) for providing its own hold value to the second L-value adder (23) as the other input. The second data latch (25) holds an output of the second L-value adder (23) in response to the reference signal fref or the output signal fdiv of the variable divider (2).

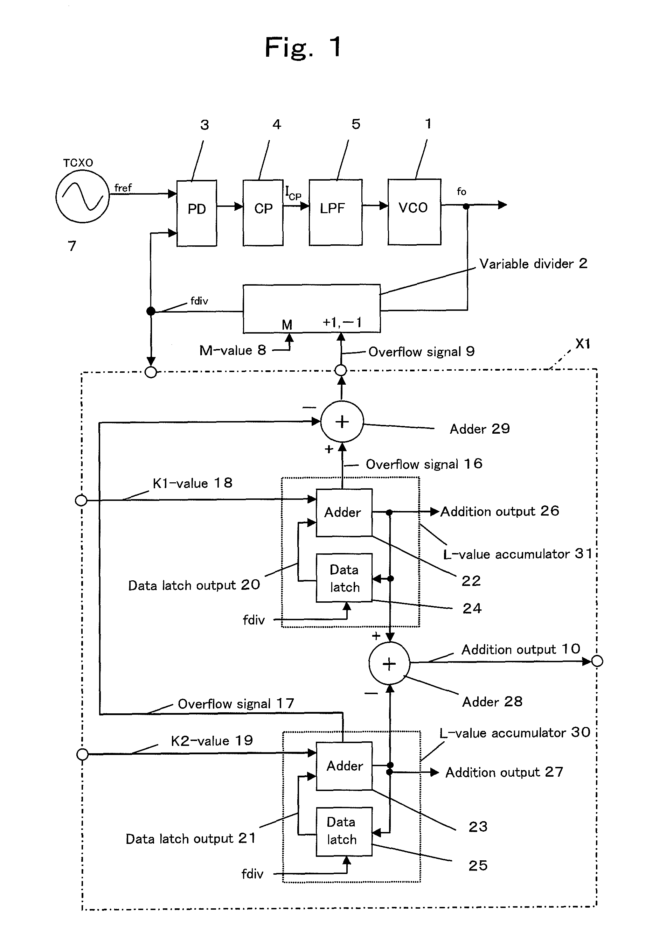

The operation of the above-mentioned delta-sigma type fraction division PLL synthesizer is described below. As a countermeasure against the low frequency spurious that cannot be attenuated by the loop filter (5) among the spurious generated by the cause (b) described above, two L-value accumulators (31, 30) are employed as shown in Fig. 1, in place of the L-value accumulator (11) constructed from a single circuit in the prior art. Then, for a desired fraction division ratio data K-value (15), a K1-value (18) and a K2-value (19) (both are integer values) that satisfy

$$\text{K-value (15)} = \text{K1-value (18)} - \text{K2-value (19)} \quad \ldots (2)$$

are inputted to the first L-value accumulator (31) and the second L-value accumulator (30). For example, when a K-value (15) =1 need be set up, a K1-value (18) =5 and a K2-value (19) =4 that satisfy Equation (2) are set up.

By virtue of this, the operation noise of the first L-value accumulator 1 (31) and the second L-value accumulator 2 (30) shifts from a low frequency spurious $\Delta f=fref\times(1/L)$ in the prior art to high frequency components like $\Delta f1=fref\times(5/L)$ and $\Delta f2=fref\times(4/L)$. Accordingly, the spurious generated by the cause of periodic operation noise of the L-value accumulators (31, 30) is attenuated almost completely by the loop filter (5).

Further, in the above-mentioned configuration of the delta-sigma type fraction division PLL synthesizer of the present invention, when the following construction is employed, a delta-sigma type fraction division PLL synthesizer is obtained that has a configuration of n-th order higher than second order. That is, in this delta-sigma type fraction division PLL synthesizer, in the above-mentioned configuration of the delta-sigma type fraction division PLL synthesizer, a second adder is further provided that subtracts the output value of the second L-value accumulator (specifically, the output value of the second L-value adder) from the output value of the first L-value accumulator (specifically, the output value of the first L-value adder). Further, n stages ranging from a first stage to a n-th stage of delta sigma sections are provided that are constructed from the first L-value accumulator, the second L-value accumulator, the first adder, and the second adder. Furthermore, provided are: first through (n-1)-th differentiation circuits for differentiating an overflow signal of each of the second stage through the n-th stage delta sigma sections respectively once through n-1 times; a third adder for adding an overflow signal of the first stage delta sigma section and an output of the first through (n-1)-th differentiation circuits; and a distributor that receives an output value of the second adder inputted to the next stage delta sigma section, and then distributes the value into two values in such a manner that the total of the two values should equal the output value of the second adder.

EFFECT OF THE INVENTION

According to the delta-sigma type fraction division PLL synthesizer of the present invention, first and second L-value accumulators are provided. The difference between overflow signals of the first and the second L-value accumulators is acquired by an adder, so that in response to an output signal of the adder, a division ratio of a variable divider is switched between M, M+1, and M-1. By virtue of this, the frequency of a spurious generated by operation noise of the first and the second L-value accumulators is shifted to a frequency component higher than the prior art. As a result, the operation noise is easily removed by a filter (lowpass filter) 5 so that reduction of a spurious is achieved.

BRIEF DESCRIPTION OF THE DRAWINGS

[Fig. 1] Fig. 1 is a block diagram showing a configuration of a delta-sigma type fraction division PLL synthesizer of Embodiment 1 of the present invention.

[Fig. 2] Fig. 2 is a timing chart showing time-dependent change in signals of respective parts of an accumulator and in a division ratio of a variable divider in Embodiment 1 of the present invention.

[Fig. 3] Fig. 3 is a block diagram showing a configuration of a prior art of a delta-sigma type fraction division PLL synthesizer.

[Fig. 4] Fig. 4 is a timing chart showing time-dependent change in signals of respective parts of an accumulator and in a division ratio of a variable divider in a prior art of a delta-sigma type fraction division PLL synthesizer.

[Fig. 5] Fig. 5 is a block diagram showing a configuration of a delta-sigma type fraction division PLL synthesizer of Embodiment 2 of the present invention.

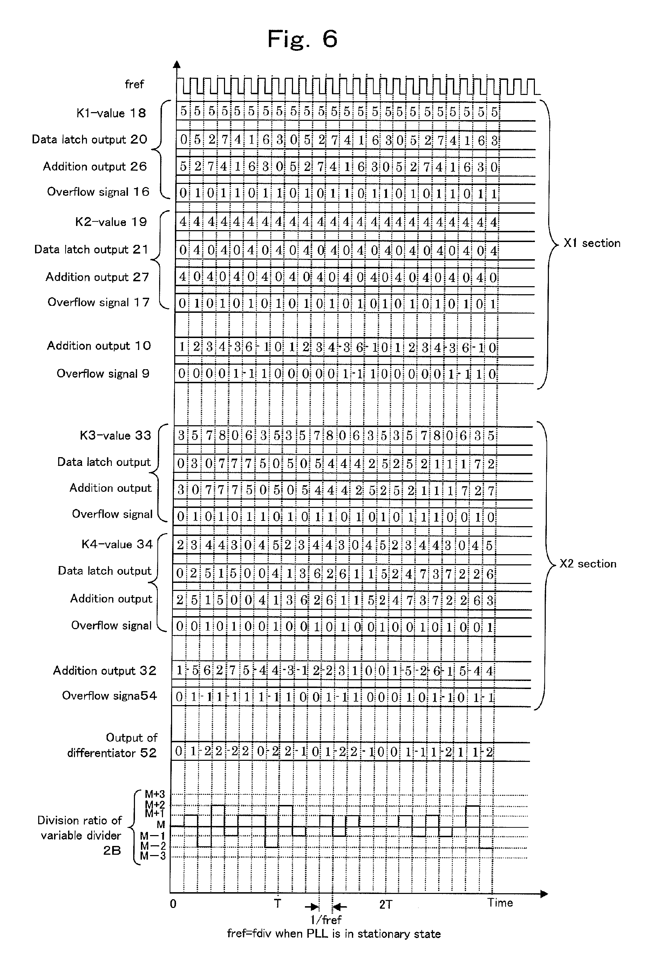

[Fig. 6] Fig. 6 is a timing chart showing time-dependent change in signals of respective parts of an accumulator and in a division ratio of a variable divider in Embodiment 2 of the present invention.

[Fig. 7] Fig. 7 is a block diagram showing a configuration of a delta-sigma type fraction division PLL synthesizer of Embodiment 3 of the present invention.

DESCRIPTION OF REFERENCE NUMERALS

| | |
|---|---|
| 1 | Voltage controlled oscillator |
| 2 | Variable divider |
| 3 | Phase comparator |
| 4 | Charge pumping circuit |
| 5 | Loop filter |
| 7 | Temperature compensated oscillator |
| 8 | M-value |
| 9 | Overflow signal |
| 10 | Addition output |
| 11 | Accumulator |
| 12 | Adder |
| 13 | Data latch |
| 14 | Data latch output |
| 15 | K-value |
| 16 | Overflow signal |
| 17 | Overflow signal |
| 18 | K1-value |
| 19 | K2-value |
| 20 | Data latch output |
| 21 | Data latch output |
| 22 | L-value adder |
| 23 | L-value adder |
| 24 | Data latch |
| 25 | Data latch |
| 26 | Adder output |
| 27 | Adder output |
| 28 | Adder |
| 29 | Adder |
| 30, 31 | Accumulator |
| 32 | Adder output |
| 33 | K3-value |
| 34 | K4-value |
| 51 | Distributor |
| 52 | Differentiator |
| 53 | Adder |
| 54 | Overflow signal |

BEST MODE FOR CARRYING OUT THE INVENTION

Embodiments are described below with reference to the drawings.

[Embodiment 1]

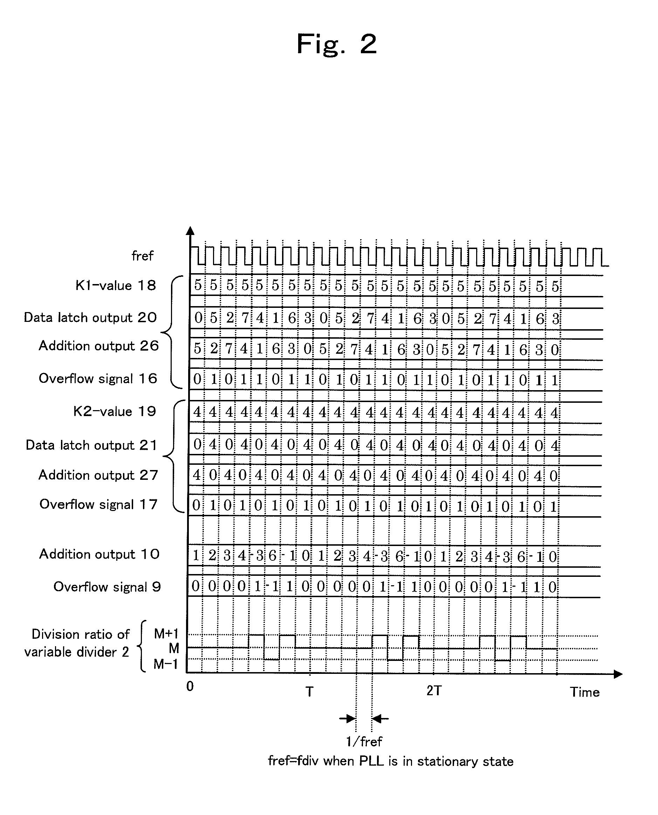

A delta-sigma type fraction division PLL synthesizer of Embodiment 1 of the present invention is described below with reference to Figs. 1 and 2.

As shown in Fig. 1, in the delta-sigma type fraction division PLL synthesizer, a reference signal fref outputted from a temperature compensated oscillator (TCXO) 7 is applied on one input terminal of a phase comparator (PD) 3. Further, an output signal fo of a voltage controlled oscillator (VCO) 1 is frequency-divided by a variable divider 2 and then outputted as a signal fdiv. The signal fdiv outputted from the variable divider 2 is applied on the other input terminal of the phase comparator 3. As a result, the phase difference between the reference signal fref and the signal fdiv is detected by the phase comparator (PD) 3. Then, a voltage pulse having a pulse width corresponding to the phase difference between the reference signal fref and the signal fdiv is transmitted from the phase comparator 3 to a charge pumping circuit (CP) 4.

From the charge pumping circuit 4, a charge pump output current Icp is outputted that can take any one of the states of discharging and suctioning of the current and the state of high impedance (Hi-Z) in response to the voltage pulse outputted from the phase comparator 3. The charge pump output current Icp is smoothed by a loop filter 5 constructed from a low pass filter, then converted into a voltage, and then inputted as a control voltage to the voltage controlled oscillator 1.

As described above, the output signal fo of the voltage controlled oscillator 1 is frequency-divided by the variable divider 2 and then fed back as the comparison signal fdiv to the phase comparator 3.

Thus, when the division ratio of the variable divider 2 is expressed by [M+ (K/L)] while the frequency of the reference signal fref is denoted by fref, the frequency of the output signal fo of the voltage controlled oscillator 1 (the frequency is denoted by the same symbol fo as the output signal fo itself, for simplicity) is expressed as follows.

$$\mathrm{fo=[M+(K/L)]\times fref} \quad \dots(3)$$

Here, M, K, L: positive integer values,
M: Integer part division ratio, and
K/L: Decimal part division ratio.

The variable divider 2 is provided with: an integer division ratio input terminal for inputting a value 8 of the integer part division ratio M; and a division ratio switching terminal for inputting a signal for changing the division ratio from M to M+1 or M-1. This configuration allows the division ratio to be switched to M, (M+1), or (M-1). Specifically, in a usual state, that is, when a signal having a zero value is inputted as a division ratio switching signal, the variable divider 2 has a division ratio of M. Then, when a signal having a positive value is inputted as a division ratio switching signal to the division ratio switching terminal, the division ratio is changed into (M+1). Further, when a signal having a negative value is inputted as a division ratio switching signal, the division ratio is changed into (M-1). This realizes an average division ratio of [M+(K/L)].

Such changing of the division ratio can be implemented by an L-value accumulator 31 and 30 and an adder 29 that constitute a delta sigma section X1. That is, the L-value accumulator 31 accumulates a value K1 (18) (K1 is an integer). Further, the L-value accumulator 30 (L is a positive integer) accumulates a value K2 (19) (K2 is an integer). Then, the adder 29 subtracts an overflow signal 17 of the L-value accumulator 30 from an overflow signal 16 of the L-value accumulator 31, and thereby outputs an overflow signal 9.

Here, the values K1 (18) andK2 (19) are set into respective values that satisfy K1-K2=K and have absolute values larger than a value K (K is a positive integer). Further, the overflow signal 9 which is the output signal of the adder 29 is inputted to the division ratio switching terminal.

As a result, when the overflow signal 9 of the adder 29 has a zero value, the division ratio of the variable divider 2 is set into M. Further, when the overflow signal 9 of the adder 29 has a positive value, the division ratio of the variable divider 2 is set into (M+1). Furthermore, when the overflow signal 9 of the adder 29 has a negative value, the division ratio of the variable divider 2 is set into (M-1). By virtue of this, the average division ratio of the variable divider 2 is set into M+(K/L).

The L-value accumulator 31 generates an overflow signal 16 when the accumulated value reaches a value L. Specifically, the L-value accumulator 31 is constructed from: an L-value adder 22 that receives a fraction division ratio data K1-value 18 as one input; and a data latch 24 for providing its own hold value, that is, a data latch output 20, to the L-value adder 22 as the other input. The data latch 24 holds an addition output 26 of the L-value adder 22 in response to the reference signal fref or the output signal fdiv of the variable divider 2. In the L-value accumulator 31, its addition output value 26 increases by the K1-value 18 in response to a clock (signal) equal to the reference signal fref or the output signal fdiv of the variable divider 2.

Similarly to the above-mentioned L-value accumulator 31, the L-value accumulator 30 generates an overflow signal 17 when the accumulated value reaches a value L. Specifically, the L-value accumulator 30 is constructed from: an L-value adder 23 that receives a fraction division ratio data K2-value 19 as one input; and a data latch 25 for providing its own hold value, that is, a data latch output 21, to the L-value adder 23 as the other input. The data latch 25 holds an addition output 27 of the L-value adder 23 in response to the reference signal fref or the output signal fdiv of the variable divider 2. In the L-value accumulator 30, its addition output value 27 increases by the K2-value 19 in response to a clock (signal) equal to the reference signal fref or the output signal fdiv of the variable divider 2.

An adder 28 adds the outputs of the L-value adders 22 and 23, and thereby generates an addition output 10. The addition output 10 is used when a higher-order delta-sigma type fraction division PLL synthesizer is constructed by employing the present delta-sigma type fraction division PLL synthesizer. Thus, it may be omitted in the configuration of Fig. 1.

According to the above-mentioned configuration of the delta sigma section X1, when overflow occurs only in the L-value adder 22, the division ratio becomes M+1 . When overflow occurs only in the L-value adder 23, the division ratio becomes M-1. Further, when overflow occurs in both of the L-value adders 22 and 23, or alternatively when overflow occurs in none of the L-value adders 22 and 23, the division ratio remains at M.

The delta sigma section X1 is described below in further detail with reference to Fig. 2. Fig. 2 shows: the reference signal fref; the K1-value 18; the output 20 of the data latch 24; the addition output 26 of the L-value adder 22; the overflow signal 16; the K2-value 19; the output 21 of the data latch 25; the addition output 27 of the L-value adder 23; the overflow signal 17; the addition output 10 of adder 28; the overflow signal 9; and the division ratio of the variable divider 2, in the case that the division ratio=K/L=1/8, K1=5, and K2=4.

As described above, the L-value accumulator 31 is constructed from: the L-value adder 22 that receives the fraction division ratio data K1-value 18 and the output 20 of the data latch 24 and thereby outputs the overflow signal 16; and the data latch 24 that receives the output 26 of the L-value adder 22 and the reference signal fref or fdiv. Further, as described above, the L-value accumulator 30 is constructed from: the L-value adder 23 that receives the fraction division ratio data K2-value 19 and the output 21 of the data latch 25 and thereby outputs the overflow signal 17; and the data latch 25 that receives the output 27 of the L-value adder 23 and the reference signal fref or fdiv.

The adder 28 subtracts the addition output 27 of the L-value adder 23 from the addition output 26 of the L-value adder 22, and thereby outputs the addition output 10. The adder 29 subtracts the overflow signal 17 of the L-value adder 23 from the overflow signal 16 of the L-value adder 22, and thereby outputs the overflow signal 9.

In the circuit of the prior art, in the case of setup of fref=200 kHz, L=8, and K-value (15) =1, the spurious component caused by the periodic operation noise of the L-value accumulator 11 has

$$\Delta f = 200 \text{ kHz} \times (1/8) = 25 \text{ kHz}$$

That is, a spurious has been generated at a frequency detuned by 25 kHz relative to the output signal fo of the voltage controlled oscillator 1.

On the other hand, in the configuration of Embodiment 1 of the present invention, in the case of setup similar to that described above, for example, K1-value 18 =5 and K2-value 19 =4 are set up. Here, the K1-value 18 and the K2-value 19 are set into allowable large values (values having absolute values larger than the value K) that satisfy Equation (2) described above. By virtue of this, the detuning frequency Δf of the spurious component caused by the periodic operation noise of the L-value accumulator 31 and the L-value accumulator 30 becomes large in comparison with the prior art case. This permits easy attenuation by the loop filter 5.

Quantitative description is given below. The detuning frequencies Δf1 and Δf2 of the spurious respectively generated by the cause of periodic operation noise of the L-value accumulator 31 and the L-value accumulator 30 in the case of K1-value (18) =5 and K2-value (19) =4 become as follows.

$$\Delta f1 = 200 \text{ kHz} \times (5/8) = 125 \text{ kHz}$$

$$\Delta f2 = 200 \text{ kHz} \times (4/8) = 100 \text{ kHz}$$

As seen from this, the detuning frequency of the spurious shifts to high frequency components in comparison with the prior art. Accordingly, the spurious generated by the cause of periodic operation noise of the L-value accumulator 31 and the L-value accumulator 30 is attenuated almost completely by the loop filter 5.

Further, in the prior art shown also in Non-Patent Document 3, the spurious of low frequency range has increased when K/L of the division ratio has a specific value (such as $1/2^n$). However, in the present circuit, the K1-value 18 and the K2-value 19 are both selected at values other than $1/2^m$ (m is an integer value), so that an effect is obtained that the spurious of low frequency range is alleviated.

[Embodiment 2]

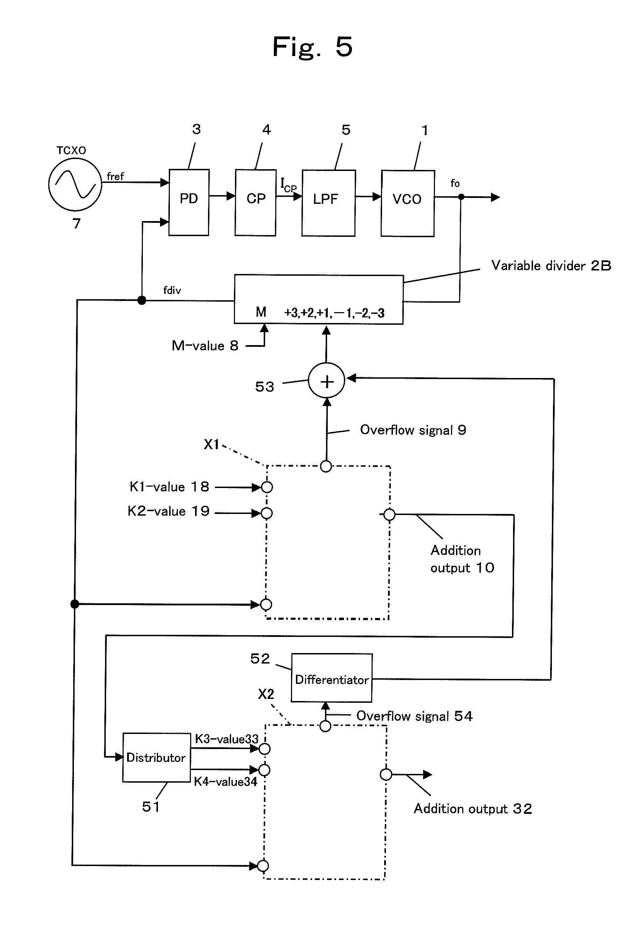

A higher-order delta-sigma type fraction division PLL synthesizer of Embodiment 2 of the present invention is described below with reference to Fig. 5.

In the higher-order delta-sigma type fraction division PLL synthesizer, as shown in Fig. 5, a variable divider 2B having a division ratio switchable between M+3, M+2, M+1, M, M-1, M-2, and M-3 is provided in place of the variable divider 2 (Embodiment 1; see Fig. 1). Further, in order that a division ratio switching signal for the variable divider 2B should be generated, a first delta sigma section X1, a second delta sigma section X2, a distributor 51, a differentiator 52, and an adder 53 are provided in place of the delta sigma section X1 (Embodiment 1; see Fig. 1). The other points in the configuration are similar to those of the configuration of Fig. 1.

The first and the second delta sigma sections X1 and X2 in Fig. 5 have the same configuration as that shown in Embodiment 1 (indicated by numeral X1). Further, the distributor 51 distributes the value K inputted to the second delta sigma X2, in accordance with the condition shown in Embodiment 1. The input value K to the second delta sigma section X2 is the addition output 10 of the first delta sigma section X1. That is, the addition output 10 is distributed by the distributor 51 as follows, and then inputted to the second delta sigma section X2.

The distributor 51 distributes the addition output 10 into a K3-value 33 and a K4-value 34. The method of distribution is similar to that of Embodiment 1. That is, "K3" and "K4" are set into values (integers) that satisfy "K3"-"K4"="addition output 10" and that have absolute values larger than the value of "addition output 10". Here, the purpose of setting "K3" and "K4" into values larger than the value of "addition output 10" is to avoid the spurious of low frequency generated when "K3" and "K4" are small as described above. However, "K3" and "K4" need not necessarily be larger than the value of "addition output 10".

An overflow signal 54 which is the output of the second delta sigma section X2 is differentiated by the differentiator 52. Then, the output of the differentiator 52 is added by the adder 53 to the overflow signal 9 which is the output of the delta sigma section X1. Further, the output signal of the adder 53 is provided as the division ratio switching signal to the variable divider 2B.

Here, as shown in Fig. 2, the overflow signals 9 and 54 of the delta sigma sections X1 and X2 change, for example, as ...0, +1, -1, +1, 0.... When each signal is differentiated, that is, when the difference is acquired between two consecutive values, ...1, -2, +2, -1... is obtained. When the differential values of the overflow signal 9 and the overflow signal 54 are added to each other, the maximum value in the addition results in the combination of the respective values is +3, while the minimum value is -3. Thus, in the variable divider 2B, in response to the addition result inputted from the adder 53, the division ratio is switched into any one of M+3, M+2, M+1, M, M-1, M-2, and M-3 as described above.

As a result, in Embodiment 2 of the present invention, a "MASH" is constructed in which a plurality of delta sigma circuits are interconnected. This provides an effect similar to that described in the above-mentioned Non-Patent Document 2, and is hence advantageous in noise reduction.

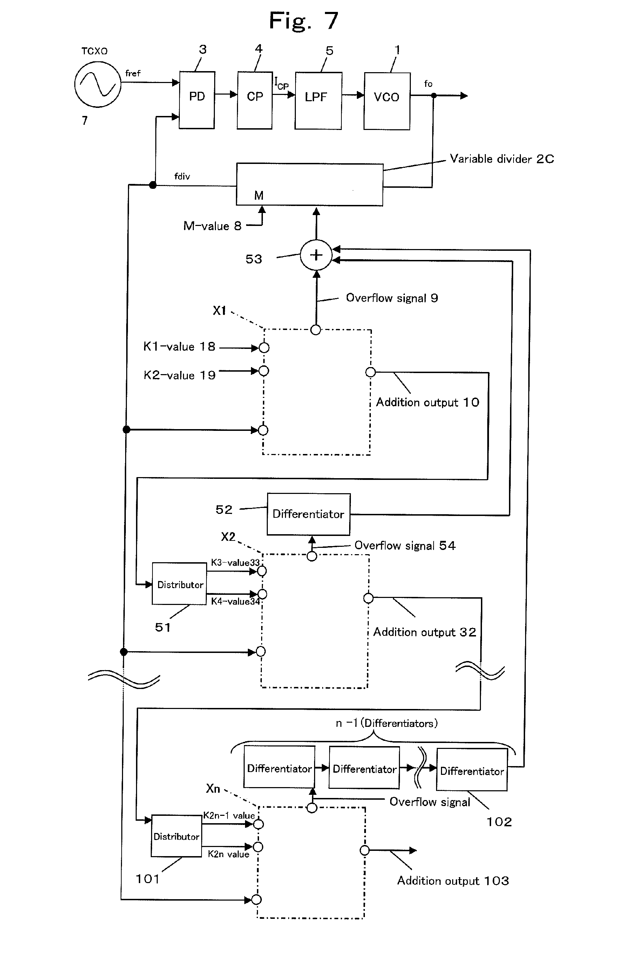

Embodiment 2 has been described for a example of configuration of second order. However, as shown in Fig. 7, a configuration of "n-th order" may be employed by using n delta sigma sections X1-Xn in a similar manner. As a result, a delta-sigma type fraction division PLL synthesizer is constructed that has the characteristics of low noise and low spurious. In Fig. 7, numeral 101 indicates a distributor, while numeral 102 indicates each of n-1 differentiators, and while numeral 103 indicates an addition output.

INDUSTRIAL APPLICABILITY

A delta-sigma type fraction division PLL synthesizer according to the present invention is applicable to mobile communication devices such as a portable telephone that require the effect of low spurious.

**Claims**

1. A delta-sigma type fraction division PLL synthesizer comprising: a voltage controlled oscillator; a variable divider that has a division ratio switchable between M (M is a positive integer), (M+1), and (M-1) and performs frequency dividing of an output signal of said voltage controlled oscillator; a phase comparator for performing phase comparison of an output signal of said variable divider with a reference signal; a filter for smoothing an output signal of said phase comparator and then providing the signal to said voltage controlled oscillator; a first L-value accumulator (L is a positive integer) for accumulating a value K1 (K1 is an integer); a second L-value accumulator for accumulating a value K2 (K2 is an integer) ; and a first adder for subtracting an overflow signal of said second L-value accumulator from an overflow signal of said first L-value accumulator, wherein

said value K1 and K2 are set into values that satisfy K1-K2=K and have absolute values larger than a value K (K is an integer), while an output signal of said first adder is provided as a division ratio switching signal to said variable divider, so that when the output signal of said first adder has a zero value, the division ratio of said variable divider is set into M, while when the output signal of said first adder has a positive value, the division ratio of said variable divider is set into M+1, and while when the output signal of said first adder has a negative value, the division ratio of said variable divider is set into M-1.

**2.** A delta-sigma type fraction division PLL synthesizer according to claim 1, wherein the first L-value accumulator comprises: a first L-value adder that receives the value K1 (K1 is an integer) as one input; and a first data latch that holds an output of said first L-value adder in response to said reference signal or alternatively the output signal of said variable divider and then provides the hold value to said first L-value adder as the other input, and wherein the second L-value accumulator comprises: a second L-value adder that receives the value K2 (K2 is an integer) as one input; and a second data latch that holds an output of said second L-value adder in response to said reference signal or alternatively the output signal of said variable divider and then provides the hold value to said second L-value adder as the other input.

**3.** A delta-sigma type fraction division PLL synthesizer according to claim 1, further comprising
a second adder for subtracting the output value of said second L-value accumulator from the output value of said first L-value accumulator, comprising
n stages ranging from a first stage to a n-th stage of delta sigma sections constructed from said first L-value accumulator, said second L-value accumulator, said first adder, and said second adder, and comprising:

first through (n-1)-th differentiation circuits for differentiating an overflow signal of each of the second stage through the n-th stage delta sigma sections respectively once through n-1 times; a third adder for adding an overflow signal of said first stage delta sigma section and an output of said first through (n-1)-th differentiation circuits; and a distributor that receives an output value of said second adder having been inputted to the next stage delta sigma section, and then distributes the value into two values in such a manner that the total of the two values should equal the output value of said second adder.

**4.** A delta-sigma type fraction division PLL synthesizer according to claim 2, further comprising
a second adder for subtracting the output value of said second L-value adder from the output value of said first L-value adder, comprising
n stages ranging from a first stage to a n-th stage of delta sigma sections constructed from said first L-value accumulator, said second L-value accumulator, said first adder, and said second adder, and comprising:

first through (n-1)-th differentiation circuits for differentiating an overflow signal of each of the second stage through the n-th stage delta sigma sections respectively once through n-1 times; a third adder for adding an overflow signal of said first stage delta sigma section and an output of said first through (n-1)-th differentiation circuits; and a distributor that receives an output value of said second adder having been inputted to the next stage delta sigma section, and then distributes the value into two values in such a manner that the total of the two values should equal the output value of said second adder.

# Fig. 1

# Fig. 2

fref=fdiv when PLL is in stationary state

# Fig. 3

# Fig. 4

fref=fdiv when PLL is in stationary state

# Fig. 5

# Fig. 6

| | Signal | Values |
|---|---|---|
| fref | | (clock pulses) |
| K1-value 18 | | 5 5 5 5 5 5 5 5 5 5 5 5 5 5 5 5 5 5 5 5 5 5 5 5 |
| Data latch output 20 | | 0 5 2 7 4 1 6 3 0 5 2 7 4 1 6 3 0 5 2 7 4 1 6 3 |
| Addition output 26 | | 5 2 7 4 1 6 3 0 5 2 7 4 1 6 3 0 5 2 7 4 1 6 3 0 |
| Overflow signal 16 | | 0 1 0 1 1 0 1 1 0 1 0 1 1 0 1 1 0 1 0 1 1 0 1 1 |
| K2-value 19 | | 4 4 4 4 4 4 4 4 4 4 4 4 4 4 4 4 4 4 4 4 4 4 4 4 |
| Data latch output 21 | | 0 4 0 4 0 4 0 4 0 4 0 4 0 4 0 4 0 4 0 4 0 4 0 4 |
| Addition output 27 | | 4 0 4 0 4 0 4 0 4 0 4 0 4 0 4 0 4 0 4 0 4 0 4 0 |
| Overflow signal 17 | | 0 1 0 1 0 1 0 1 0 1 0 1 0 1 0 1 0 1 0 1 0 1 0 1 |
| Addition output 10 | | 1 2 3 4 3 6 -1 0 1 2 3 4 3 6 -1 0 1 2 3 4 3 6 -1 0 |
| Overflow signal 9 | | 0 0 0 0 1 -1 1 0 0 0 0 0 1 -1 1 0 0 0 0 0 1 -1 1 0 |
| K3-value 33 | | 3 5 7 8 0 6 3 5 3 5 7 8 0 6 3 5 3 5 7 8 0 6 3 5 |
| Data latch output | | 0 3 0 7 7 7 5 0 5 0 5 4 4 4 2 5 2 5 2 1 1 1 7 2 |
| Addition output | | 3 0 7 7 7 5 0 5 0 5 4 4 4 2 5 2 5 2 1 1 1 7 2 7 |
| Overflow signal | | 0 1 0 1 0 1 1 0 1 0 1 1 0 1 0 1 0 1 1 1 0 0 1 0 |
| K4-value 34 | | 2 3 4 4 3 0 4 5 2 3 4 4 3 0 4 5 2 3 4 4 3 0 4 5 |
| Data latch output | | 0 2 5 1 5 0 0 4 1 3 6 2 6 1 1 5 2 4 7 3 7 2 2 6 |
| Addition output | | 2 5 1 5 0 0 4 1 3 6 2 6 1 1 5 2 4 7 3 7 2 2 6 3 |
| Overflow signal | | 0 0 1 0 1 0 0 1 0 0 1 0 1 0 0 1 0 0 1 0 1 0 0 1 |
| Addition output 32 | | 1 -5 6 2 7 5 -4 4 -3 -1 2 -2 3 1 0 0 1 -5 -2 6 -1 5 -4 4 |
| Overflow signa54 | | 0 1 -1 1 -1 1 1 -1 1 0 0 1 -1 1 0 0 0 1 0 1 -1 0 1 -1 1 |
| Output of differentiator 52 | | 0 1 -2 2 -2 2 0 -2 2 -1 0 1 -2 2 -1 0 0 1 -1 1 -2 1 1 -2 |

Division ratio of variable divider 2B (scale: M+3, M+2, M+1, M, M−1, M−2, M−3)

Time axis: 0 — T — 2T

1/fref

fref=fdiv when PLL is in stationary state

X1 section

X2 section

# Fig. 7

## INTERNATIONAL SEARCH REPORT

| International application No. |
|---|
| PCT/JP2004/018405 |

**A. CLASSIFICATION OF SUBJECT MATTER**
Int.Cl$^7$ H03L7/197, H03L7/183, H03M7/32

According to International Patent Classification (IPC) or to both national classification and IPC

**B. FIELDS SEARCHED**

Minimum documentation searched (classification system followed by classification symbols)
Int.Cl$^7$ H03L7/16-7/23

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2005 |
| Kokai Jitsuyo Shinan Koho | 1971-2005 | Jitsuyo Shinan Toroku Koho | 1996-2005 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 05-502154 A (Motorola, Inc.), 15 April, 1993 (15.04.93), Page 4, lower left column, line 24 to page 5, lower right column, line 20; Fig. 3 & US 5070310 A  & WO 1992/004766 A1 | 1-4 |

| ☐ Further documents are listed in the continuation of Box C. | ☐ See patent family annex. |
|---|---|

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 March, 2005 (07.03.05) | 22 March, 2005 (22.03.05) |

| Name and mailing address of the ISA/ | Authorized officer |
|---|---|
| Japanese Patent Office | |
| Facsimile No. | Telephone No. |

Form PCT/ISA/210 (second sheet) (January 2004)